# EUROPÄISCHE PATENTSCHRIFT

(11) **EP 2 446 286 B1**
(45) Veröffentlichungstag und Bekanntmachung des Hinweises auf die Patenterteilung: **22.01.2014**
(21) Anmeldenummer: 10728167.7
(22) Anmeldetag: 21.06.2010
(51) Int. Cl.: G01R 31/36

(54) **Warnsystem für Batteriesysteme**
Warning system for battery systems
Système d'avertissement pour les systèmes d'accumulateurs

(30) Priorität: 25.06.2009 DE 102009027177
(43) Veröffentlichungstag der Anmeldung: 02.05.2012
(73) Patentinhaber: Samsung SDI Co., Ltd., Gyeonggi-do (KR); Robert Bosch GmbH, 70442 Stuttgart (DE)
(72) Erfinder: YAN, Xiaofeng, 71384 Weinstadt (DE)
(74) Vertreter: Bee, Joachim
(86) Internationale Anmeldenummer: PCT/EP2010/058719
(87) Internationale Veröffentlichungsnummer: WO 2010/149613

(56) Entgegenhaltungen:
- DE-B4- 10 165 041
- US-A- 5 900 734

## Beschreibung

### Stand der Technik

Batteriesysteme umfassen wiederaufladbare elektrische Energiespeicher, die einen breiten Einsatz in tragbaren Konsumgeräten und anderen Anwendungen finden, wie z.B. in teilweise oder ausschließlich elektrisch betriebenen Fahrzeugen. In automobilen Anwendungen gelten Batteriesysteme und insbesondere Lithium-lonen-Batteriesysteme als Schlüsseltechnologie für die Elektrifizierung des Antriebssystems von Fahrzeugen. Batteriesysteme und insbesondere Lithium-lonen-Batteriesysteme können dabei je nach Einsatzspezifikation modular aufgebaut sein und sind meist seriell oder parallel elektrisch verschaltet.

Ein wesentlicher Aspekt für die erfolgreiche Etablierung dieser Technologie ist u.a. die Betriebssicherheit der Batteriesysteme, speziell der Lithium-lonen-Batteriesysteme, die nicht selten mit großen Kapazitäten betrieben werden. Dabei ist es erforderlich das Batteriesystem innerhalb eines optimalen Temperaturbereichs zu betreiben. Denn die Batterietemperatur hat einen großen Einfluss auf die Leistungsbereitstellung, Alterung, Lebensdauer und Betriebssicherheit des Batteriesystems. Um dies zu gewährleisten weisen Batteriesysteme meist ein ausgefeiltes thermisches Managementkonzept auf.

Während des Betriebs von Batteriesystemen kann es vorkommen, dass die Temperatur in der Batterie derart ansteigt, dass diese sich nicht mehr durch äußere Kühlsysteme abkühlen lässt. Hauptursache für solche Temperaturverläufe sind interne Kurzschlüsse in der Batterie, hervorgerufen beispielsweise durch physische Deformationen der Batterie oder durch Verunreinigungen bei der Herstellung der Batterie (z.B. Beschädigung des Separators durch Partikel). Ein interner Kurzschluss kann weitere elektrochemische irreversible Prozesse in der Batterie in Gang setzten, bei denen Wärme frei gesetzt wird (exotherme Reaktionen). Schließlich kann es zu einem sog. "thermal runaway", einer Art selbstbeschleunigter Überhitzung, kommen. Eine andere mögliche Ursache für irreversible Temperaturzunahmen einer Batterie ist eine Überladung der Batterie.

Üblicherweise weisen Batteriesysteme Sicherheitsmaßnahmen auf, die der Vermeidung eines "thermal runaway" des Batteriesystems dienen. Solche Sicherheitsmaßnahmen umfassen beispielsweise Temperatur-, Spannungs- und/oder Stromüberwachungs- sowie Stromunterbrechungsvorrichtungen. Diese Sicherheitsmaßnahmen liegen meist in einem Batterie Management System des Batteriesystems integriert vor oder werden durch das Batterie Management System gesteuert. Ziel ist es dabei die Gefahr einer irreversiblen Überhitzung frühzeitig zu erkennen und gegebenenfalls die Batterie schnell vom restlichen Stromnetz zu trennen.

Warnsysteme für Batterien sind aus US 5 900 734 und DE 101 65 041 B4 bekannt.

Allerdings bieten solche Sicherheitsmaßnahmen keinen umfassenden Schutz davor, dass eine Batterie überhitzt und es zur Entstehung eines Brandes kommen kann. Dies stellt insbesondere dann ein Problem dar, wenn das Batteriesystem in der direkten Umgebung von Menschen betrieben wird, wie beispielsweise im Fall von Batteriesystemen für Fahrzeuge.

Aufgabe der vorliegenden Erfindung ist es, Mittel bereitzustellen, die das Gefährdungsrisiko für Menschen, das vom Betrieb eines Batteriesystems ausgeht, zu vermindern oder ganz zu vermeiden.

### Offenbarung der Erfindung

Die Aufgabe wird gelöst durch die Merkmale des Anspruchs 1.

Über die Sensoren zur Zustandsüberwachung des Batteriesystems werden kontinuierlich Messdaten erhalten, die einen Rückschluss auf den Zustand des Batteriesystems zulassen. Die Messdaten werden einer Regel- und Steuereinheit zugeführt und dort mit einem vorher festgelegten Referenzwert verglichen. Dabei ist der mindestens eine Referenzwert so gewählt, dass sich bei einer signifikanten Abweichung zwischen Messwert und Referenzwert bzw. bei einem Über- bzw. Unterschreiten des Referenzwertes, das Batteriesystem in einem kritischen Zustand befindet oder die Wahrscheinlichkeit des Eintritts eines kritischen Zustands erhöht ist. Ist dies der Fall, so löst die Regel- und Steuereinheit die Ausgabe von Warnsignalen aus.

Das erfindungsgemäße Warnsystem erlaubt es, dass Personen, die sich in der Nähe eines Batteriesystems befinden, welches sich in einem kritischen Zustand befindet, über den Zustand des Batteriesystems rechtzeitig informiert werden, so dass sich die Personen gegebenenfalls aus dem Gefahrenbereich entfernen können ohne Schaden zu nehmen und/oder die Möglichkeit haben, geeignete Maßnahmen zu ergreifen, um eine vollständige Havarie des Batterisystems zu vermeiden oder deren Folgen zu vermindern. Handelt es sich bei dem Batteriesystem beispielsweise um ein Lithium-Ionen-Batteriesystem, welches in einem Fahrzeug als Bestandteil des elektrifizierten Antriebs zum Einsatz kommt, so wird der Vorteil des erfindungsgemäßen Warnsystems besonders deutlich. Kommt es während der Fahrt zu einer Überhitzung des Batteriesystems, so informiert das erfindungsgemäße Warnsystem den Fahrer durch Ausgabe von Warnsignalen über den kritischen Zustand der Batterie. Der Fahrer hat nun Gelegenheit das Fahrzeug geregelt zum Stillstand zu bringen, sicher abzustellen und sich dann vom Fahrzeug zu entfernen, bevor er durch einen Batteriebrand verletzt wird. Damit wird eine Gefährdung des Fahreres sowie der Umwelt vermindert.

Das erfindungsgemäße Warnsystem eignet sich zur Überwachung von Batteriesystemen, insbeondere von Lithium-Ionen-Batteriesystemen. Besonders vorteilhaft eignet sich das Warnsystem für die Überwachung von Batteriesystemen mit großer Leistung bzw. mit hohen Kapazitäten.

Unter einem Batteriesystem wird dabei eine Anordnung zur Versorgung eines Netzes bzw. eines Verbrauchers mit elektrischer Energie verstanden, die eine Batterie mit mindestens einem elektrochemischen Energiespeicher umfasst. Unter einem Energiespeicher kann für die Zwecke der vorliegenden Erfindung jeder Energiespeicher verstanden werden, der eine Energie mittels elektrochemischer Prozesse speichert. Insbesondere sind darunter Energiespeicher zu verstehen, die eine oder mehrere in Reihe und/oder gegebenenfalls auch parallel geschalteter Akkumulator- und/oder Batteriezellen enthalten. Bevorzugte Energiespeicher können Brennstoffzellen, insbesondere vom Typ alkalische Brennstoffzelle (AFC), Polymerelektrolytbrennstoffzelle (PEMFC), Direktmethanolbrennstoffzelle (DMFC), Phosphorsäurebrennstoffzelle (PAFC), Schmelzkarbonatbrennstoffzelle (MCFC) und/oder Festoxidbrennstoffzelle (SOFC) aufweisen. Weitere bevorzugte elektrochemische Energiespeicher können Akkumulatorzellen, insbesondere vom Typ Pb - Bleiakku, NiCd - Nickel-Cadmium-Akku, NiH₂ - Nickel-Wasserstoff-Akkumulator, NiMH - Nickel-Metallhydrid-Akkumulator, Li-lon - Lithium-lonen-Akku, LiPo - Lithium-Polymer-Akku, LiFe - Lithium-Metall-Akku, Li-Mn - Lithium-Mangan-Akku, LiFePO₄ - Lithium-Eisen-Phosphat-Akkumulator, LiTi - Lithium-Titanat-Akku, Doppelschichtkondensator (supercaps, electrochemical double layer capacitor EDLC), RAM - Rechargeable Alkaline Manganese, Ni-Fe - Nickel-Eisen-Akku, Na/NiCl - Natrium-Nickelchlorid-Hochtemperaturbatterie-Batterie, SCiB - Super Charge Ion Battery, Silber-Zink-Akku, Silikon-Akku, Vanadium-Redox-Akkumulator und/oder Zink-Brom-Akku aufweisen. Der Energiespeicher kann eine oder mehrere Zellen aufweisen. Neben einer solchen Batterie kann ein Batteriesystem weitere Bestandteile umfassen, wie beispielsweise ein Gehäuse, Sicherheitsvorrichtungen zum Abschalten der Batterie oder zum Trennen der Batterie vom restlichen Netz und/oder ein Batterie Management System, welches Regel- und Steuereinheiten umfassen kann, die zum Betrieb, zur geregelten Beund Entladung, sowie zur Sicherheitsüberwachung der Batterie dienen. Das Batterie Management System weist dazu Mittel auf, um Daten z.B. über den Batteriezustand aufzunehmen, zu verarbeiten, zu speichern, mit anderen Daten oder Werten zu vergleichen und gegebenenfalls Steuersignale an andere Komponenten des Batteriesystems oder anderer Vorrichtungen zu senden. Dazu kann das Batterie Management System beispielsweise eine Eingangs-, eine Speicher-, eine Rechen- und/oder eine Ausgangseinheit aufweisen.

Bevorzugt dient das Warnsystem der Überwachung von Lithium-lonen-Batteriesystemen, insbesondere von Lithium-lonen-Batteriesystemen mit einer nominalen Kapazität von ≥ 2Ah, bevorzugt von ≥ 3Ah.

Das erfindungsgemäße Warnsystem weist einen oder mehrere Sensoren auf, die der Zustandsüberwachung des Batteriesystems dienen. Dabei sind die Sensoren derart ausgestaltet, dass diese bei Betrieb des Warnsystems Messdaten über Parameter des Batteriesystems ermitteln können, wobei die Parameter so ausgewählt sind, dass eine Veränderung im Zustand des Batteriesystems eine messbare Veränderung des ausgewählten Parameters zur Folge hat. Geeignete Parameter und Sensortypen sind dem Fachmann bekannt und können je nach Typ, Dimension und Einsatzort des Batteriesystems ausgewählt werden. Beispiele für geeignete Sensortypen sind:
- Temperatursensoren, die Daten über den Temperaturzustand des Batteriesystems oder Teilen davon bereit stellen. Dabei wird die Tatsache ausgenutzt, dass eine Temperaturerhöhung im Batteriesystem ein Indikator dafür sein kann, dass sich das Batteriesystem in einem kritischen Zustand befindet oder die Wahrscheinlichkeit für das baldige Erreichen eines kritischen Zustandes des Batteriesystems erhöht ist.
- Drucksensoren, die einen ggf. plötzlichen, pulsartigen Druckanstieg messen können, wie er beispielsweise bei einer Batteriesystembeschädigung durch einen Sturz auftreten kann. Dabei wird die Tatsache genutzt, dass eine Druckerhöhung im Batteriesystem ein Indikator dafür sein kann, dass sich das Batteriesystem in einem kritischen Zustand befindet oder die Wahrscheinlichkeit für das baldige Erreichen eines kritischen Zustandes des Batteriesystems erhöht ist.
- Gassensoren, die Daten über eine Freisetzung eines bestimmten Gases oder Gasgemisches innerhalb oder aus dem Batteriesystem ermitteln können. Insbesondere kann es sich hier um Gassensoren handeln, die reaktiv sind für Gase oder Gasgemische enthaltend H₂, CO und/oder CO₂. Hierbei wird die Tatsache ausgenutzt, dass die Freisetzung von bestimmten Gasen ein Indikator dafür sein kann, dass sich das Batteriesystem in einem kritischen Zustand befindet oder die Wahrscheinlichkeit für das baldige Erreichen eines kritischen Zustandes des Batteriesystems erhöht ist.
- Spannungssensoren, die Daten über die Kräfteverteilung (Statik) in und/oder an dem Batteriesystem oder Teilen davon liefern. Insbesondere können solche Sensoren Daten über Veränderungen von Spannungen im Batteriesystemgehäuse bereit stellen. Hierbei wird die Tatsache ausgenutzt, dass eine Veränderung im Spannungskräfteverhältnis ein Hinweis auf eine Beschädigung des Batteriesystems und damit ein Indikator dafür sein kann, dass sich das Batteriesystem in einem kritischen Zustand befindet oder die Wahrscheinlichkeit für das baldige Erreichen eines kritischen Zustandes des Batteriesystems erhöht ist.
- Elektrische Spannungssensoren, die Daten über elektrische Spannungen innerhalb des Batteriesystems liefern können. Hierbei wird die Tatsache genutzt, dass eine ggf. plötzlich auftretende Veränderung in elektrischen Spannungswerten z.B. innerhalb einzelner oder mehrerer Zellen der Batterie des Batteriesystems ein Indikator dafür sein kann, dass sich das Batteriesystem in einem kritischen Zustand befindet oder die Wahrscheinlichkeit für das baldige Erreichen eines kritischen Zustandes des Batteriesystems erhöht ist.
- Bewegungssensoren, die Daten über eine Stoßbewegung innerhalb des Batteriesystems und/oder auf das Batteriesystem einwirkend erfassen können. Insbesondere kann es sich dabei um Sensoren handeln, die beispielsweise eine Stoßbewegung eines im oder am Batteriesystem angebrachten Referenzobjekt erfassen können. Hierbei wird die Tatsache ausgenutzt, dass die Detektion einer Stoßbewegung ein Hinweis auf eine Beschädigung des Batteriesystems und damit ein Indikator dafür sein kann, dass sich das Batteriesystem in einem kritischen Zustand befindet oder die Wahrscheinlichkeit für das baldige Erreichen eines kritischen Zustandes des Batteriesystems erhöht ist.

Das erfindungsgemäße Warnsystem weist Sensoren zur Zustandsüberwachung von Batteriesystemen auf, die unabhängig voneinander ausgewählt sind aus den Sensortypen Temperatursensor, Drucksensor, Gassensor, Spannungssensor, elektrischer Spannungssensor und/oder Bewegungssensor.

Das erfindungsgemäße Warnsystem kann mehr als einen Sensor zur Zustandsüberwachung von Batteriesystemen aufweisen, wobei das Warnsystem Sensoren eines einzigen Sensortyps oder jede gewünschte Kombination unterschiedlicher Sensortypen umfassen kann.

Insbesondere können im erfindungsgemäßen Warnsystem einer, mehrere oder alle Sensoren zur Zustandsüberwachung von Batteriesystemen direkt mit einem Bestandteil des Batteriesystems verbindbar ausgebildet sein.

Das erfindungsgemäße Warnsystem weist Mittel zur Ausgabe von Warnsignalen aus. Unter Warnsignalen werden dabei solche vom Menschen wahrnehmbare Signale verstanden, die üblicherweise dazu geeignet sind die Aufmerksamkeit der zu warnenden Personen zu erregen. Die Auswahl des einen oder der mehreren gleichen oder verschiedenen Warnsignale kann also davon abhängen, in welcher Form und Umgebung sich die zu warnende Person während des Betriebs des erfindungsgemäßen Warnsystems üblicherweise befindet. Dem Fachmann sind solche geeignete Warnsignale oder Kombinationen von Warnsignalen bekannt. Bevorzugt sind die Mittel zur Ausgabe von Warnsignalen derart ausgestaltet, dass akustisch und/oder optisch wahrnehmbare Warnsignale ausgegeben werden können bzw. ausgebbar sind. Beispielsweise können als Mittel zur Ausgabe von optisch wahrnehmbaren Warnsignalen Lampen und/oder Rauchgasfreisetzende Mittel eingesetzt werden. Als Mittel zur Ausgabe von akustisch wahrnehmbaren Warnsignalen können z.B. Lautsprecher eingesetzt werden.

Zusätzlich zu Mitteln zur Ausgabe von Warnsignalen weist das erfindungsgemäße Warnsystem Mittel auf zur Übermittlung von Positionsangaben des Warnsystems. Dabei sind diese Mittel zur Übermittlung von Positionsangaben insbesondere über die Regel- und Steuereinheit auslösbar und werden bevorzugt dann ausgelöst, wenn auch mindestens ein Mittel zur Ausgabe eines Warnsignals ausgelöst wird. Solche Mittel umfassen beispielsweise GPS-Systeme oder andere Vorrichtungen, die eine Ortung des Warnsystems erlauben, wie z.B. die Aussendung von Mobilfunksignalen, die von einer Servicezentrale oder Notrufstelle z.B. der Polizei oder Feuerwehr empfangen und ausgewertet werden können.

Das erfindungsgemäße Warnsystem weist weitere zusätzliche Mittel und Vorrichtungen auf, wie beispielsweise Aktoren, die über die Regel- und Steuereinheit auslösbar sind und bevorzugt dann ausgelöst werden, wenn auch mindestens ein Mittel zur Ausgabe eines Warnsignals ausgelöst wird. Solche Aktoren können sicherheitsrelevante Maßnahmen einleiten oder vornehmen. Die Aktoren können beispielsweise Stellmotoren umfassen, die ein oder mehrere Fenster und/oder Türen eines Fahrzeugs entriegeln und/oder öffnen. Mittels dieser Aktoren können auch Maßnahmen ausgelöst, eingeleitet oder vorgenommen werden, die direkt oder indirekt auf das Batteriesystem einwirken mit dem Ziel den kritischen Zustand des Batteriesystems zu beeinflussen, insbesondere zu verhindern, dass das Batteriesystem in Brand gerät oder weitere Schäden am Batteriesystem oder der Umwelt entstehen. Beispielsweise können über solche Aktoren Kühlsysteme ausgelöst oder bedient werden oder das Batteriesystem vom restlichen Netz getrennt werden.

Das erfindungsgemäße Warnsystem weist eine Regel- und Steuereinheit auf, welche mit den Sensoren zur Zustandsüberwachung von Batteriesystemen und mit den Mitteln zur Ausgabe von Warnsignalen derart verbunden ist, dass Messwerte der Sensoren von der Regel- und Steuereinheit aufgenommen, verarbeitet und mit einem Referenzwert verglichen werden können und bei Feststellung einer Abweichung eines Messwerts von einem Referenzwert die Mittel zur Ausgabe von Warnsignalen auslösbar sind. Insbesondere kann diese Regel- und Steuereinheit in ein, ggf. bereits vorhandenes, Batterie Management System des zu überwachenden Batteriesystems integriert vorliegen. Dabei sind Sensoren und Regel- und Steuereinheit derart aufeinander abgestimmt, dass Messdaten der Sensoren durch die Regel- und Steuereinheit aufgenommen, verarbeitet, ggf. gespeichert, und mit einem Referenzwert verglichen werden können, wobei der Referenzwert derart ausgewählt und vorher festgelegt ist, dass bei einer Abweichung des Messwertes vom Referenzwert eine erhöhte Wahrscheinlichkeit für das Bestehen oder den Eintritt eines kritischen Zustandes des Batteriesystems vorliegt, beispielsweise einen Kurzschluss oder einen doppelten Isolationsfehler. Die genaue Festlegung des oder der Referenzwerte kann sowohl vom verwendeten Batteriesystem abhängen als auch von den eingesetzten Sensoren und Sensortypen und kann ggf. für jedes Warnsystem neu bestimmt und ggf. vor erstmaliger Inbetriebnahme des erfindungsgemäßen Warnsystems festgelegt werden. Der Referenzwert kann dabei ein fester oder ein dynamischer, schwankender Wert sein, der beispielsweise aus einem mathematischen Modell oder einem Kennlinienfeld des Batteriesystems abgeleitet werden kann. Der Refernezwert kann aber auch kontinuierlich neu ermittelt und festgelegt werden. Der Referenzwert kann beispielsweise aus einem Schwellenwert gebildet werden, der eine gerade noch zu tolerierende Differenz eines Sollwertes mit den ermittelten Messdaten des Batteriesystems wiedergibt. Die Messwerte eines oder mehrerer Sensoren werden mit einem bestimmten Referenzwert verglichen und es wird festgestellt, ob einer der Messwerte von dem Referenzwert ausserhalb eines Toleranzbereichs abweicht. Wird eine Abweichung eines Messwertes von einem Referenzwert festgestellt, so löst das Warnsystem ein Signal aus. Die erfindungsgemäße Regel- und Steuereinheit kann eine oder mehrere Speicher-, Rechen- und/oder Steuereinheiten aufweisen, die derart ausgestaltet und abgestimmt sind, dass der gewünschte Abgleich der Messwerte mit einem Referenzwert bewerkstelligt und die entsprechenden Massnahmen, z.B. Auslösung von Mitteln zur Ausgabe von Warnsignalen, einleitbar sind. Die Regel- und/oder Steuereinheit kann ggf. auch derart ausgeführt sein, dass sie die Abweichung eines oder mehrerer Messwerte registrieren kann, die zwar gerade noch kein Warnsignal auslöst, aber dem Auftritt eines kritischen Zustands des Batteriesystems vorausgeht. Häuft sich die Anzahl solcher semikritischer Abweichungen gegenüber einem vom Fachmann festgelegten Referenzwert, kann auch ein Warnsignal ausgelöst werden. Beispielsweise kann der Fahrzeugführer darüber informiert werden, dass das mit dem Batteriesystem ausgestattete Fahrzeug zur Werkstatt gebracht werden soll. lese registrierten Informationen können ihrerseits von einem Diagnosegerät abrufbar sein.

Insbesondere kann das erfindungsgemäße Warnsystem derart ausgestaltet sein, dass Messwerte der Sensoren mit mehr als einem Referenzwert vergleichbar sind und je nach festgestellter Abweichung verschiedene Warnsignale ausgebbar sind. Dadurch lässt sich ein abgestufter Warnprozess erreichen, bei dem beispielsweise der Zustand des Batteriesystems in mehrere Gefährdungsstufen eingeteilt wird, je nach Ausprägung der festgestellten Abweichung der Messwerte von einem oder mehreren Referenzwerten. Die Zustände des Batteriesystems können z.B. in einen Normlazustand eingeteilt werden, bei dem keiner der Messwerte der Sensoren von einen bestimmten Referenzwert abweicht; in einen ersten Gefährdungszustand, bei dem einer oder mehrere Messwerte der Sensoren von einem ersten Referenzwert abweichen aber nicht von einem zweiten; und einem zweiten Gefährdungszustand, bei dem einer oder mehrere Messwerte der Sensoren sowohl von einem ersten als auch von einem zweiten Referenzwert abweichen. Dabei kann der erste Referenzwert so gewählt sein, dass bei einer Abweichung ein Gefährdungszustand eintritt, bei dem der Eintritt eines kritischen Zustandes des Batteriesystems zwar wahrscheinlich ist, aber noch keine unmittelbare Gefahr für Personen besteht. Ein zweiter Referenzwert kann beispielsweise so gewählt sein, dass bei einer Abweichung davon ein Gefährdungszustand eintritt, bei dem ein kritischer Zustand des Batteriesystems bereits eingetreten ist und eine unmittelbare Gefahr für Personen und/oder Umgebung besteht. Dabei kann das Warnsystem derart ausgebildet sein, dass je nach dem welcher der Referenzwerte über- oder unterschritten ist, unterschiedliche Warnsignale ausgelöst werden. So kann eine Person über den tatsächlich vorliegenden Gefährdungszustand eines Batteriesystems in Abhängigkeit des gemessenen Batteriesystemzustands informiert werden und die Person kann entsprechend reagieren und für den jeweiligen Gefährdungszustand angemessene Schritte einleiten.

Die vorliegende Erfindung bezieht sich auch auf ein Batteriesystem umfassend ein erfindungsgemäßes Warnsystem, wobei das Warnsystem in das Batteriesystem integriert oder als separate, damit verbindbare oder verbundene Vorrichtung vorliegen kann.

Die vorliegende Erfindung umfasst auch einen elektrischen Verbraucher, der ein erfindungsgemäßes Warnsystem oder Batteriesystem enthält. Dabei kommt es nicht darauf an, dass Verbraucher und Warn- bzw. Batteriesystem eine bauliche Einheit bilden, sondern, dass Verbraucher und erfindungsgemäßes Warn- bzw. Batteriesystem derart funktional in Kontakt stehen, dass das Warn- bzw. Batteriesystem seine Warnfunktion während des Betriebs des elektrischen Verbrauchers erfüllen kann. Insbesondere kann der Verbraucher ein Kraftfahrzeug sein. Dabei sind unter dem Begriff "Kraftfahrzeug" alle angetriebenen Fahrzeuge zu verstehen, die ein Batteriesystem zur Energieversorgung von mindestens einer Komponente des Kraftfahrzeugs aufweisen, unabhängig davon welchen Antrieb diese Kraftfahrzeuge aufweisen. Insbesondere umfasst der Begriff "Kraftfahrzeug" HEV (elektrische Hybridfahrzeuge), PHEV (Plug-In-Hybridfahrzeuge), EV (Elektrofahrzeuge), Brennstoffzellenfahrzeuge, sowie alle Fahrzeuge, die ein Batteriesystem zur mindestens teilweisen Versorgung mit elektrischer Energie einsetzen.

### Figuren:

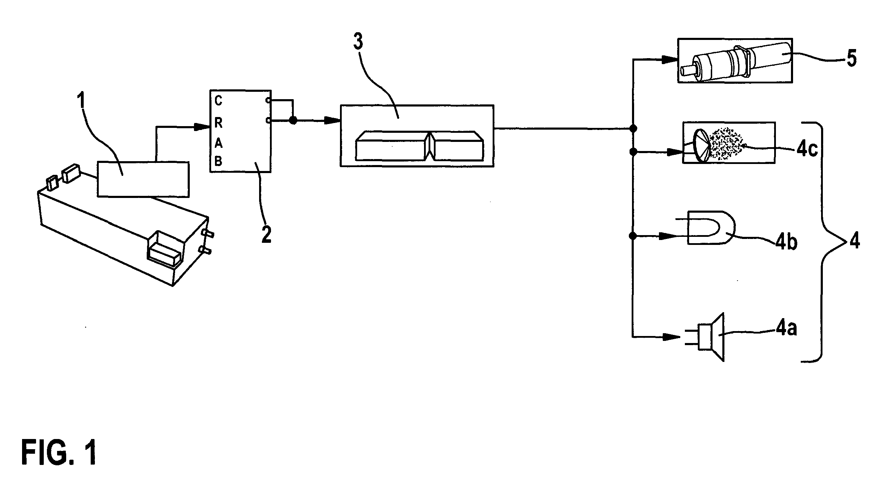

- FIG. 1: zeigt eine schematische Darstellung einer Ausführungsform eines erfindungsgemäßen Warnsystems.

### Bezugszeichenliste:

- 1: Batteriesystem
- 2: Sensor zur Zustandsüberwachung von Batteriesystemen
- 3: Regel- und Steuereinheit
- 4: Mittel zur Ausgabe von Warnsignalen
- 4a: Lautsprecher
- 4b: Lampe
- 4c: Mittel zur Freisetzung von farbigem Rauchgas
- 5: Aktor

### Beispielhafte Ausführungsform der Erfindung:

In FIG. 1 ist eine mögliche Ausführungsform eines erfindungsgemäßen Warnsystems schematisch dargestellt. Der Zustand eines Batteriesystems 1 wird mittels eines Sensors zur Zustandsüberwachung des Batteriesystems 1 überwacht. Dieser Sensor 2 ist derart mit einer Regel- und Steuereinheit 3 verbunden, dass Messwerte des Sensors 2 von der Regel- und Steuereinheit 3 aufgenommen und verarbeitet werden können. Die Regel- und Steuereinheit 3 ist dabei derart ausgebildet, dass sie Messwete des Sensors 2 aufnehmen und mit einem vorher festgelegten Referenzwert vergleichen kann. Weicht ein Messwert vom Referenzwert ab, so kann die Regel- und Steuereinheit 3 die Ausgabe eines Warnsignals auslösen. Zu diesem Zweck ist die Regel- und Steuereinheit 3 mit Mitteln zur Ausgabe von Warnsignalen 4 derart verbunden, dass die Regel- und Steuereinheit 3 durch Übermittlung eines Steuerbefehls die Ausgabe eines Warnsignals auslösen kann. Im in FIG. 1 dargestellten Beispiel ist die Regel- und Steuereinheit 3 mit drei unterschiedlichen Mitteln 4 zur Ausgabe von Warnsignalen verbunden, mit einem Lautsprecher 4a zur Ausgabe eines akustischen Signals und mit einer Lampe 4b und einem Mittel zur Freisetzung eines farbigen Rauchgases 4c, jeweils zur Ausgabe eines optischen Signals. Zusätzlich weist das erfindungsgemäße Warnsystem noch einen Aktor 5 auf, der bei Auslösung eines Warnsignals ebenfalls aktiviert werden kann und sicherheitsrelevante Maßnahmen einleiten oder vornehmen kann.

## Patentansprüche

1. Warnsystem für Batteriesysteme (1), umfassend
a) einen oder mehrere Sensoren (2) zur Zustandsüberwachung von Batteriesystemen;
b) Mittel zur Ausgabe von Warnsignalen (4); und
c) eine Regel- und Steuereinheit (3), die mit den Sensoren aus a) und mit den Mitteln zur Ausgabe von Warnsignalen aus b) derart verbunden ist, dass Messwerte der Sensoren von der Regel- und Steuereinheit aufgenommen, verarbeitet und mit einem Referenzwert verglichen werden und bei Feststellung einer Abweichung eines Messwerts von einem Referenzwert die Mittel zur Ausgabe von Warnsignalen (4) auslösbar sind, wobei das Warnsystem zusätzlich Mittel aufweist zur über die Regel- und Steuereinheit auslösbaren Übermittlung von Positionsangaben des Warnsystems, **dadurch gekennzeichnet, dass** der oder die Sensoren zur Zustandsüberwachung von Batteriesystemen unabhängig voneinander ausgewählt sind aus den Sensortypen Temperatursensor, Drucksensor, Gassensor, Spannungssensor, elektrischer Spannungssensor und/oder Bewegungssensor und das Warnsystem zusätzlich Aktoren (5) aufweist mit denen Maßnahmen vorgenommen werden, die direkt oder indirekt auf das Batteriesystem einwirken und über die Regel- und Steuereinheit ausgelöst werden.

2. Warnsystem nach Anspruch 1, **dadurch gekennzeichnet, dass** das Warnsystem mehr als einen Sensor (2) zur Zustandsüberwachung von Batteriesystemen (1) aufweist, wobei das Warnsystem Sensoren eines einzigen Sensortyps oder unterschiedlicher Sensortypen umfasst.

3. Warnsystem nach einem der vorhergehenden Anspruch, **dadurch gekennzeichnet, dass** einer, mehrere oder alle Sensoren (2) zur Zustandsüberwachung von Batteriesystemen direkt mit einem Bestandteil des Batteriesystems (1) verbindbar ausgebildet sind.

4. Warnsystem nach einem der vorhergehenden Ansprüche, **dadurch gekennzeichnet, dass** die Regel- und Steuereinheit (3) in einem Batterie. Management System des Bätteriesystems integriert vorliegt.

5. Warnsystem nach einem der vorhergehenden Ansprüche, **dadurch gekennzeichnet, dass** die Mittel zur Ausgabe von Warnsignalen (4) derart ausgestaltet sind, dass akustisch und/oder optisch wahrnehmbare Warnsignale ausgebbar sind.

6. Warnsystem nach einem der vorhergehenden Ansprüche, **dadurch gekennzeichnet, dass** das Warnsystem derart ausgestaltet ist, dass Messwerte der Sensoren mit mehr als einem Referenzwert vergleichbar sind und je nach festgestellter Abweichung verschiedene Warnsignale ausgebbar sind.

7. Batteriesystem umfassend ein Warnsystem nach einem der Ansprüche 1 bis 6.

8. Elektrischer Verbraucher enthaltend ein Warnsystem nach einem der Ansprüche 1 bis 6 oder ein Batteriesystem nach Anspruch 7.

9. Elektrischer Verbraucher nach Anspruch 8, **dadurch gekennzeichnet, dass** der elektrische Verbraucher ein Kraftfahrzeug ist.

## Claims

1. Warning system for battery systems (1), comprising
a) one or more sensors (2) for monitoring the state of battery systems;
b) means for outputting warning signals (4); and
c) a regulating and control unit (3) which is connected to the sensors from a) and to the means for outputting warning signals from b) in such a manner that measured values from the sensors are recorded and processed by the regulating and control unit and are compared with a reference value, and the means for outputting warning signals (4) can be triggered if a difference between a measured value and a reference value is determined, the warning system additionally having means for transmitting position information relating to the warning system, which transmission can be triggered via the regulating and control unit, **characterized in that** the sensor(s) for monitoring the state of battery systems is/are independently selected from the sensor types of temperature sensor, pressure sensor, gas sensor, voltage sensor, electrical voltage sensor and/or motion sensor, and the warning system additionally has actuators (5) which are used to carry out measures which directly or indirectly act on the battery system and are triggered via the regulating and control unit.

2. Warning system according to Claim 1, **characterized in that** the warning system has more than one sensor (2) for monitoring the state of battery systems (1), the warning system comprising sensors of a single sensor type or different sensor types.

3. Warning system according to one of the preceding claims, **characterized in that** one, more or all sensors (2) for monitoring the state of battery systems are designed so that they can be directly connected to a part of the battery system (1).

4. Warning system according to one of the preceding claims, **characterized in that** the regulating and control unit (3) is integrated in a battery management system of the battery system.

5. Warning system according to one of the preceding claims, **characterized in that** the means for outputting warning signals (4) are configured in such a manner that acoustically and/or optically perceptible warning signals can be output.

6. Warning system according to one of the preceding claims, **characterized in that** the warning system is configured in such a manner that measured values from the sensors can be compared with more than one reference value and different warning signals can be output depending on the difference determined.

7. Battery system comprising a warning system according to one of Claims 1 to 6.

8. Electrical load containing a warning system according to one of Claims 1 to 6 or a battery system according to Claim 7.

9. Electrical load according to Claim 8, **characterized in that** the electrical load is a motor vehicle.

## Revendications

1. Système d'alarme pour système de batteries (1), comprenant :
a) un ou plusieurs capteurs (2) qui surveillent d'état de systèmes de batteries,
b) des moyens qui délivrent des signaux d'alarme (4) et
c) une unité de régulation et de commande (3) raccordée aux capteurs de a) et aux moyens de fourniture de signaux d'alarme de b), de telle sorte que des valeurs de mesure des capteurs sont enregistrées, traitées et comparées à une valeur de référence par l'unité de régulation et de commande (3), les moyens de fourniture de signaux d'alarme (4) pouvant être activés lorsqu'un écart entre une valeur de mesure et une valeur de référence, le système d'alarme présentant de plus des moyens qui transmettent des données de position du système d'alarme lorsqu'ils sont activés par l'unité de régulation et de commande, **caractérisé en ce que**
le ou les capteurs qui surveillent l'état des systèmes de batteries sont sélectionnés indépendamment les uns des autres parmi les types de capteur que sont les capteurs de température, les capteurs de pression, les capteurs de gaz, les capteurs de contraintes, les capteurs de tension électrique et les capteurs de déplacement et
**en ce que** le système d'alarme présente de plus des actionneurs (5) qui permettent de prendre des dispositions qui agissent directement ou indirectement sur le système de batteries et qui sont activées par l'intermédiaire de l'unité de régulation et de commande.

2. Système d'alarme selon la revendication 1, **caractérisé en ce que** le système d'alarme présente plus d'un capteur (1) de surveillance de l'état de systèmes de batteries (1) et **en ce que** le système d'alarme comporte des capteurs d'un seul type ou de plusieurs types différents.

3. Système d'alarme selon l'une des revendications précédentes, **caractérisé en ce qu'**un, plusieurs ou tous les capteurs (2) de surveillance de l'état de systèmes de batteries peuvent être raccordés directement à un composant du système de batteries (1).

4. Système d'alarme selon l'une des revendications précédentes, **caractérisé en ce que** l'unité de régulation et de commande (3) est intégrée à un système de gestion de batteries du système de batteries.

5. Système d'alarme selon l'une des revendications précédentes, **caractérisé en ce que** les moyens de fourniture de signaux d'alarme (4) sont configurés de manière à pouvoir délivrer des signaux d'alarme perceptibles acoustiquement et/ou visuellement.

6. Système d'alarme selon l'une des revendications précédentes, **caractérisé en ce que** le système d'alarme est configuré de telle sorte que les valeurs de mesure des capteurs peuvent être comparées à plus d'une valeur de référence et **en ce que** différents signaux d'alarme peuvent être délivrés lorsqu'un écart est constaté.

7. Système de batteries comprenant un système d'alarme selon l'une des revendications 1 à 6.

8. Consommateur électrique contenant un système d'alarme selon l'une des revendications 1 à 6 ou un système de batteries selon la revendication 7.

9. Consommateur électrique selon la revendication 8, **caractérisé en ce que** le consommateur électrique est un véhicule automobile.
